Europäisches Patentamt

European Patent Office

Office européen des brevets

(19)

(11) Publication number: **0 087 264**
A2

(12) **EUROPEAN PATENT APPLICATION**

(21) Application number: 83300771.9

(22) Date of filing: 16.02.83

(51) Int. Cl.³: **H 01 L 29/24**

(30) Priority: 19.02.82 GB 8204913
19.02.82 GB 8204912

(43) Date of publication of application:
31.08.83 Bulletin 83/35

(84) Designated Contracting States:
DE FR IT NL

(71) Applicant: The General Electric Company, p.l.c.
1 Stanhope Gate
London W1A 1EH(GB)

(72) Inventor: Read, Eileen
The Grange 176 Chartridge
Chesham Buckinghamshire(GB)

(72) Inventor: McCaughan, Daniel Vincent
104 Gregories Road
Beconsfield Buckingshamshire(GB)

(74) Representative: Pope, Michael Bertram Wingate
The General Electric Company Limited Central Patent
Department Hirst Research Centre East Lane
Wembley Middlesex HA9 7PP(GB)

(54) Force sensors.

(57) A force sensor comprising a field effect transistor
structure (1, 3, 5, 9, 17) with a layer of piezoelectric material
(11) between the channel region (9) and the gate electrode
(17).

*Fig.1.*

EP 0 087 264 A2

0087264

This invention relates to force sensors. It has especial relevance to force sensors suitable for use as vibration sensors.

Whilst known force sensors suitable for use as vibration sensors, such as sensors based on piezoelectric ceramics, are adequate for frequencies above 100 Hz, they lose sensitivity and dynamic range below this frequency. It is one object of the invention to provide a force sensor wherein this shortcoming is at least mitigated.

According to the invention a force sensor comprises: a field effect transistor structure comprising a semiconductor substrate including a source region, a drain region and a channel region between the source and drain regions; a layer of piezoelectric material at least a portion of which overlies said channel region; and a control electrode overlying said portion of the piezoelectric material layer.

In one particular sensor in accordance with the invention said piezoelectric layer overlies a layer of insulating material which overlies said channel region.

In another particular sensor in accordance with the invention said piezoelectric layer overlies a layer of insulating material which overlies said substrate adjacent to said channel region, and a portion of said piezoelectric layer extends beyond said insulating layer so as to overhang said channel region. In such an arrangement said portion of the piezoelectric layer is typically of rectangular form.

Two force sensors in accordance with the invention suitable for use as vibration sensors will now be described, by way of example only, with reference to the accompanying drawings in which:

Figure 1 is a diagrammatic cross-sectional view of one sensor;

Figure 2 is a diagrammatic cross-sectional view of the other sensor;  and

Figure 3 is a sectional view along the line A-A' in Figure 2.

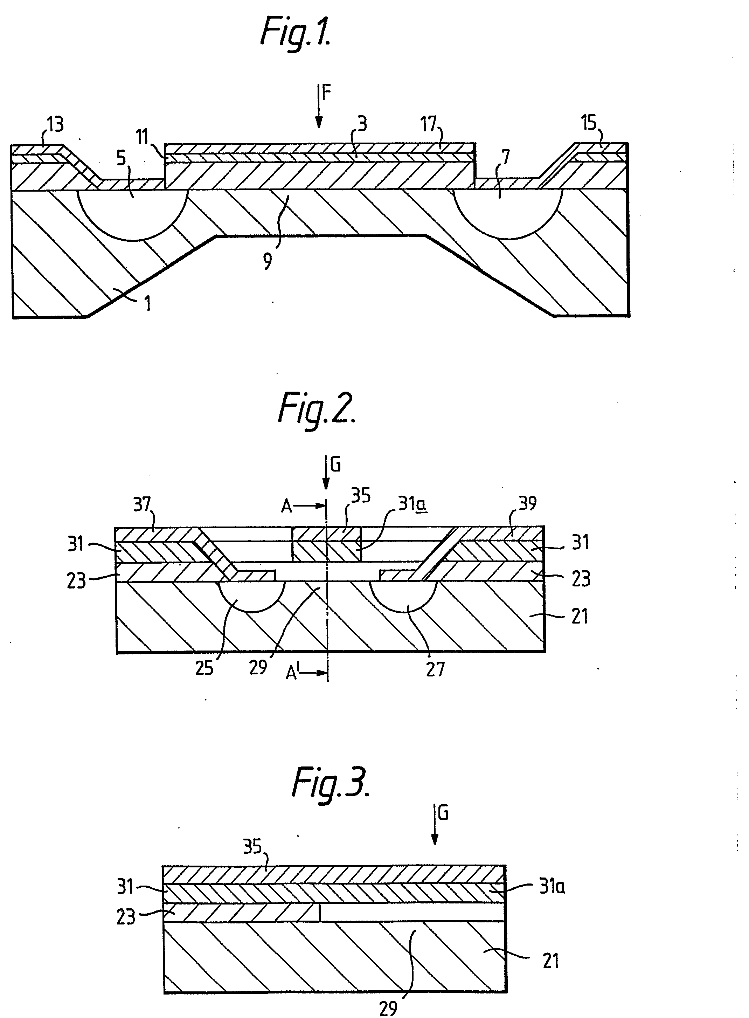

Referring to Figure 1, the first sensor to be described comprises an n-channel field effect transistor structure formed in a p-type silicon substrate 1.  Two spaced n-type regions 5 and 7 formed in the substrate 1 constitute the source and drain regions of the structure, the part of the substrate 1 between the source 5 and drain 7 constituting the channel region 9 of the structure. The region of the substrate 1 under the channel region 9 is made of reduced thickness, for example, by etching of the substrate 1 from its face opposite the channel region.

An electrically insulating layer 3 of silicon dioxide overlies the substrate 1 except over the source and drain regions where windows are provided in the layer 3.  Overlying the layer 3 is a layer of a piezoelectric material 11, for example zinc oxide or aluminium nitride.  This layer 11 may be deposited on the silicon dioxide 3 by a variety of techniques, for example magnetron sputtering.  Leads 13 and 15 contacting the source and drain respectively via windows in the silicon dioxide layer 3 and corresponding windows in piezoelectric layers 11, and a gate electrode 17 and lead thereto (not shown) are provided by selective etching of a layer of electrically conductive material e.g. aluminium, overlying the structure.

When the sensor is subject to vibration, the etched section of the silicon substrate 21 with its overlying silicon dioxide layer 13, piezoelectric layer 11 and gate electrode 17 flexes with the vibration.  This causes charge of alternating polarity to be generated by the piezoelectric layer 11 at the silicon dioxide-piezoelectric interface adjacent the channel region 9, and thus the drain current of the device will be modulated by the vibration. Provided the sensor is biassed in the most sensitive portion of its voltage/current characteristic, a linear relationship between the force which the gate electrode17, and thus the underlying piezoelectric layer 11 is subjected to, and the drain current is obtained. For a gate length of 100 μm, and a piezoelectric layer thickness of 1 μm, a sensitivity of around 70 μA per gm. is possible.

It will be appreciated that whilst the piezoelectric layer 11 extends beyond the channel region 9, this is merely for ease of manufacture of the sensor, and that the piezoelectric layer may be arranged not to extend beyond the gate electrode without having any appreciable effect on the characteristics of the sensor.

It will be understood that in a practical embodiment of the sensor it will normally be desirable to ensure that the piezoelectric layer 11 is electrically isolated from the environment to prevent surface electrical leakage and contamination. Thus a practical sensor will normally incorporate passivating layers (not shown), for example of silicon dioxide, to provide such isolation, wherever needed. It will be understood that in order to obtain highest sensitivity such passivating layers will be as thin as possible, consistant with conferring the desired isolation from the environment.

It will be appreciated that while the sensor of Figure 1 is suitable for use as a vibration sensor, it could also find other applications for example as a simple microelectronic pressure transducer, or an accelerometer, since the drain current will vary with any variation of force in the direction of the arrow F in Figure 1. In such applications the reduction of thickness of the substrate under the channel region will not be necessary.

Referring now to Figure 2, the second sensor to be described comprises an n-channel field effect transistor structure formed in a p-type silicon substrate 21. Two spaced n-type regions 25 and 27 formed in the substrate constitute the source and drain regions of the structure, the part of the substrate between the source 25 and drain 27 constituting the channel region 29 of the structure.

An electrically insulating layer 23 of silicon dioxide overlies the substrate 21 except in the area of the channel region, and over the source and drain regions 25 and 27, as further explained below.

Referring now also to Figure 3, a layer 31 of piezoelectric material, such as zinc oxide or aluminium nitride, is carried on the silicon dioxide layer 23. The piezoelectric layer 31 includes a rectangular portion 31a which extends beyond part of the edge of the silicon dioxide layer 23 so as to overhang the channel region 29. The portion 31a of the piezoelectric layer 31 is thus spaced off from the exposed surface of the channel region 19 by the thickness of the layer 23.

A gate electrode 35 and lead for the structure consisting of electrically conductive material, such as aluminium, overlies the piezoelectric layer 31. Further leads 37 and 39 contacting the source 25 and drain 27 respectively via windows in the piezoelectric layer 31 and silicon dioxide layer 23 constitute the source and drain leads of the structure. The leads and electrode 35 are suitably formed by selective etching of a layer of suitable material in conventional manner.

The overhanging part of the piezoelectric layer 31 is suitably fabricated by arranging for the silicon dioxide layer 23 to extend initially over the channel region 29, and then, after formation of the piezoelectric layer 31, removing part of the layer 23 between the piezoelectric layer 31 and the channel region 29 by anisotropic etching of the layer 23.

It will be appreciated that the part 31a of the piezoelectric layer together with the overlying gate electrode 35 form a cantilever structure free to vibrate in the direction of the arrow G in Figures 2 and 3. Thus in use, when the device is subject to vibration, the cantilever structure is caused to vibrate. The alternating stresses in the piezoelectric layer portion 31a cause charge of alternating polarity to be generated at the surfaces of the piezoelectric strip 31a. As the charge on the lower surface of the piezoelectric strip 31a affects the depth of the depletion layer in the underlaying channel region 29, the drain current of the structure is thus modulated by the vibration. In a typical device the natural frequency of the cantilever structure is in the order of 60 Hz, and thus particular sensitivity is obtained around this frequency.

It will be appreciated that the piezoelectric layer 31 extends laterally beyond the channel region 29 merely as a manufacturing convenience.

The required natural frequency and other mechanical properties of the cantilever structure may be obtained in a variety of ways. Thus the thickness and material of the layers 31 and 35 will be chosen with a view to obtaining the required mechanical properties as well as the required electrical properties. Alternatively or additionally the layer 35 may be locally thickened or local regions (not shown) of additional material may be provided to obtain a desired mass loading of the structure, or an additional layer (not shown) of suitable material may be incorporated in the structure to stiffen the structure.

It will be understood that in a practical embodiment of the sensor it will normally be desirable to ensure that the piezoelectric layer 31 and the exposed surface of the channel region 29 are electrically isolated from the environment to prevent surface electrical leakage and contamination, and in the case of the channel region, surface traps and defects. Thus, a practical sensor will normally incorporate passivating layers (not shown), for example of silicon dioxide, to provide such isolation, wherever needed. It will be understood that in order to obtain highest sensitivity such passivating layers will be as thin as possible, consistant with conferring the desired isolation from the environment.

It will be appreciated that while the sensor of Figure 2 and 3 is intended for use as a vibration sensor, it may find other applications, for example, as a pressure transducer or accelerometer, since the drain current will vary with any variation of force on the cantilever structure in the direction of the arrow G.

It will also be appreciated that electric circuit means for processing the output signal of a sensor in accordance with the invention, such as analogue-digital conversion, filtering, amplification or signal conditioning means, will normally be integrated with the sensor on the same substrate.

It will be appreciated that whilst the sensors described by way of example comprise an n-channel field effect transistor structure formed in a p-type substrate, other field effect transistor structures, for example comprising a p-channel structure formed in an n-type substrate may be used in a sensor according to the invention.

0087264

CLAIMS

1.    A force sensor characterised in that it comprises:   a field effect transistor structure comprising a semiconductor substrate (1, Fig. 1; 21, Figs 2, 3) including a source region (5, Fig. 1;   25, Figs 2, 3), a drain region (7, Fig. 1; 27 Figs 2, 3) and a channel region (9, Fig.1; 29 Figs 2, 3) between the source and drain regions;   a layer of piezoelectric material (11, Fig.1; 31,Figs 2,3) at least a portion of which overlies said channel region;   and a control electrode (17, Fig. 1; 35, Figs 2, 3) overlying said portion of the piezoelectric material layer.

2.    A sensor according to Claim 1 wherein said piezoelectric layer overlies a layer of insulating material (3, Fig. 1) which overlies said channel region.

3.    A sensor according to Claim 2 wherein the region of the substrate beneath the channel region is of reduced thickness.

4.    A sensor according to Claim 1 wherein said piezoelectric layer overlies a layer of insulating material (23, Figs 2, 3) which overlies the substrate adjacent to said channel region, and a portion (31a, Figs 2, 3) of said piezoelectric layer extends beyond said insulating layer so as to overhang said channel region.

5.    A sensor according to Claim 4 wherein said portion of said piezoelectric layer is of rectangular form.

6.    A sensor according to any preceding claim associated with electric circuit means for processing the output signal of the sensor and formed in the same substrate as the sensor.

0087264

*Fig.1.*

*Fig.2.*

*Fig.3.*